# EUROPEAN PATENT APPLICATION

(11) **EP 4 803 898 A1**
(43) Date of publication of application: **09.09.2026**
(21) Application number: 26162518.0
(22) Date of filing: 05.03.2026
(51) Int. Cl.: G01N 27/904, G01L 1/12

(54) **STRETCHABLE EDDY CURRENT SENSOR AND ASSOCIATED METHODS**

(30) Priority: 07.03.2025 US 202563768572 P
(71) Applicant: General Electric Company, Cincinnati, Ohio 45215 (US)
(72) Inventor: SHEILA VADDE, Aparna Chakrapani, 560066 Bengaluru (IN); TRIVEDI, Deepak, Niskayuna, 12309-1027 (US); KOYITHITTA MEETHAL, Manoj Kumar, 560066 Bengaluru (IN); PAVINATTO, Felippe Jose, Niskayuna, 12309-1027 (US)
(74) Representative: Openshaw & Co.

(57) **Abstract**

Eddy current sensors are provided herein that are stretchable. In some aspects, the stretchable eddy current sensors have a sensor (108) element array that is designed to act as an eddy current inspection sensor (108) and multiaxial strain sensor (108) to enable distortion compensation for measurement signals. Using strain detected by the eddy current sensors and, in some aspects, combining information about the geometry of a component (104) and position information of the sensor (108) on the component (104), corrections can be determined to make the eddy current sensor (108) readings invariant to deformations of sensor (108) elements (111) of the eddy current sensors. In other aspects, the stretchable eddy current sensors can be installed on a component (104) to be inspected for health monitoring. A baseline measurement can be acquired after installation, for example, after the stretchable eddy current sensor (108) is initially stretched, and defects detected based on changes from the baseline measurement.

## Description

### CROSS REFERENCE TO RELATED APPLICATIONS

This application claims the benefit of priority of U.S. Provisional Application No. 63/768,572, filed March 7, 2025, which is incorporated herein by reference in its entirety.

### TECHNICAL FIELD

These teachings relate generally to sensors and, in particular, to eddy current sensors.

### BACKGROUND

Eddy current inspection is a technique for detecting discontinuities or flaws in the surface of components such as the components of a gas turbine engine. Eddy current techniques are based on the principle of electromagnetic induction in which eddy currents are induced within the component under inspection. The eddy currents are induced in the component by alternating magnetic fields created by a coil of an eddy current probe, referred to as a drive coil, when the probe is excited with an alternating current and moved in proximity to the component under inspection. Changes in the flow of eddy currents are caused by the presence of a discontinuity or a crack in the test specimen. The eddy currents produce a secondary magnetic field which induces a voltage in the eddy current probe coil or in a separate sense coil in the eddy current probe which may be recorded for analysis. An eddy current machine operator may then detect and determine a size of the flaws by monitoring and analyzing the recorded voltage signals.

### BRIEF DESCRIPTION OF DRAWINGS

Various needs are at least partially met through provision of the stretchable sensors and associated methods described in the following detailed description, particularly when studied in conjunction with the drawings. A full and enabling disclosure of the aspects of the present description, including the best mode thereof, directed to one of ordinary skill in the art, is set forth in the specification, which refers to the appended figures, in which:
FIG. 1 is a block diagram of a system with a stretchable eddy current sensor, according to some embodiments;
FIG. 2 is a schematic diagram of a coil array, in accordance with some embodiments;
FIG. 3 is a schematic diagram of a device embodying the system of FIG. 1, according to some embodiments;
FIG. 4 is a schematic diagram of a coil of a stretchable eddy current sensor that has been deformed, according to some embodiments;
FIG. 5A is a schematic diagram of an eddy current sensor array in an undeformed state, according to some embodiments;
FIG. 5B is a schematic diagram of an eddy current sensor array in a deformed state, according to some embodiments;
FIG. 5C is a flow diagram of a method for applying corrections to measurements of the eddy current sensor of FIGS. 5A and 5B, according to some embodiments;
FIG. 6 is a flow diagram of a method for determining corrections for measurements of a stretchable eddy current sensor, according to some embodiments;
FIG. 7 is a flow diagram of a method for determining corrections for measurements of a stretchable eddy current sensor, according to some embodiments;
FIG. 8 shows equations that can be used in the methods described herein, according to some embodiments; and
FIG. 9 shows a flow diagram of a method of operating a stretchable eddy current sensor, according to some embodiments.

Elements in the figures are illustrated for simplicity and clarity and have not necessarily been drawn to scale. For example, the dimensions and/or relative positioning of some of the elements in the figures may be exaggerated relative to other elements to help to improve understanding of various embodiments of the present teachings. Also, common but well-understood elements that are useful or necessary in a commercially feasible embodiment are often not depicted in order to facilitate a less obstructed view of these various embodiments of the present teachings. Certain actions and/or steps may be described or depicted in a particular order of occurrence while those skilled in the art will understand that such specificity with respect to sequence is not actually required.

### DETAILED DESCRIPTION

Eddy current sensors, such as Eddy Current Array Probes (ECAPs), can be used for detecting flaws in material, such as surface defects on turbine engine components. Structures inspected using eddy current sensors may have complex geometries. Defect detection of some of the complex geometries can be achieved by using a flexible eddy current sensor. Typical flexible sensors, however, are only bendable to adapt to simple curves but lack the ability to conform to complex shapes and intricate geometries. Currently, single coil eddy current inspection can be used to inspect complex contours however, such an inspection may be time consuming. For complex three-dimensional contours, for example the surface of a sphere, a stretchable eddy current array sensor will enable faster inspection.

One challenge of using deformable eddy current sensor arrays is that sensor deformation alters the sensor response. For example, deformation of sensor elements in the eddy current sensor (e.g., coils) may alter the magnetic field created by the sensor and the induced eddy current. Accordingly, approaches for compensating for these effects may be useful to ensure accurate measurement of defects using the eddy current sensors.

Provided herein are stretchable eddy current sensors that include a coil array that can be used for eddy current inspection and as a multiaxial strain sensor. The stretchable eddy current sensors can stretch or deform to conform to complex shapes and multiaxial curvatures. The strain measured using the sense coil arrays of the stretchable eddy current sensors provided herein can be used in a setup operation for the stretchable eddy current sensor. For example, the strain sensed by the eddy current sense coil in a controlled deformation can be used to derive information on the shape of the coil in a deformed state and responses of the coil (e.g., magnetic field, eddy currents, inductance) in a deformed state. The responses of the coil can be used to derive a correction. The correction can be applied to measurements acquired by the stretchable eddy current sensor to make the sensor measurements invariant to sensor deformation.

As used herein, "stretchable" may refer to a material with the ability to bend, stretch, or deform about multiple axes (e.g., two or more axes) without breaking. In some examples, stretchable may refer to a material with a modulus less than or equal to 60 megapascals (MPa) and the ability to bend, stretch, or deform without breaking. In some examples, the material may have a stretch at break of greater than or equal to 25%. In other words, the material may be stretched to more than 125% of the original length before failure. In some aspects, a stretchable material may recover its original dimensions within about a 5 percent (%) tolerance when strain is removed, after elongation below the breaking limits specified above. This recovery may show time dependency and take a number of seconds or minutes to occur. Suitable stretchable materials that can be used in the stretchable layers described herein include but are not limited to polyurethanes like thermoplastic poly-urethanes (TPU); silicones such as polydimethylsiloxane (PDMS), etc.; and styrene-ethylene-butylene-styrene (SEBS).

As used herein, "flexible" refers to a material with the ability to bend, stretch, or deform about at least one axis without breaking. In some examples, a flexible material (e.g., a substrate) may flex to a bending radius of a few millimeters (mm) or less while still preserving its mechanical properties. Suitable flexible materials that can be used in the flexible layers described herein include but are not limited to polyethylene terephthalate (PET); polycarbonate (PC); polyethylene naphthalene (PEN); polyethylene (PE); polypropylene PP; and polyimide (Kapton).

As used herein, "substantially perpendicular" may refer to an orientation, in particular when viewed in a plan view, comprising an angle of about 90 degrees, the angle having a maximum deviation from 90 degrees that is less than about 10 degrees, less than about 5 degrees, and, in some aspects, less than about 2 degrees.

The terms and expressions used herein have the ordinary technical meaning as is accorded to such terms and expressions by persons skilled in the technical field as set forth above except where different specific meanings have otherwise been set forth herein. The word "or" when used herein shall be interpreted as having a disjunctive construction rather than a conjunctive construction unless otherwise specifically indicated. The terms "coupled," "fixed," "attached to," and the like refer to both direct coupling, fixing, or attaching, as well as indirect coupling, fixing, or attaching through one or more intermediate components or features, unless otherwise specified herein.

The singular forms "a", "an", and "the" include plural references unless the context clearly dictates otherwise.

Approximating language, as used herein throughout the specification and claims, is applied to modify any quantitative representation that could permissibly vary without resulting in a change in the basic function to which it is related. Accordingly, a value modified by a term or terms such as "about", "approximately", and "substantially", are not to be limited to the precise value specified. In at least some instances, the approximating language may correspond to the precision of an instrument for measuring the value, or the precision of the methods or machines for constructing or manufacturing the components and/or systems. For example, the approximating language may refer to being within a 10 percent margin.

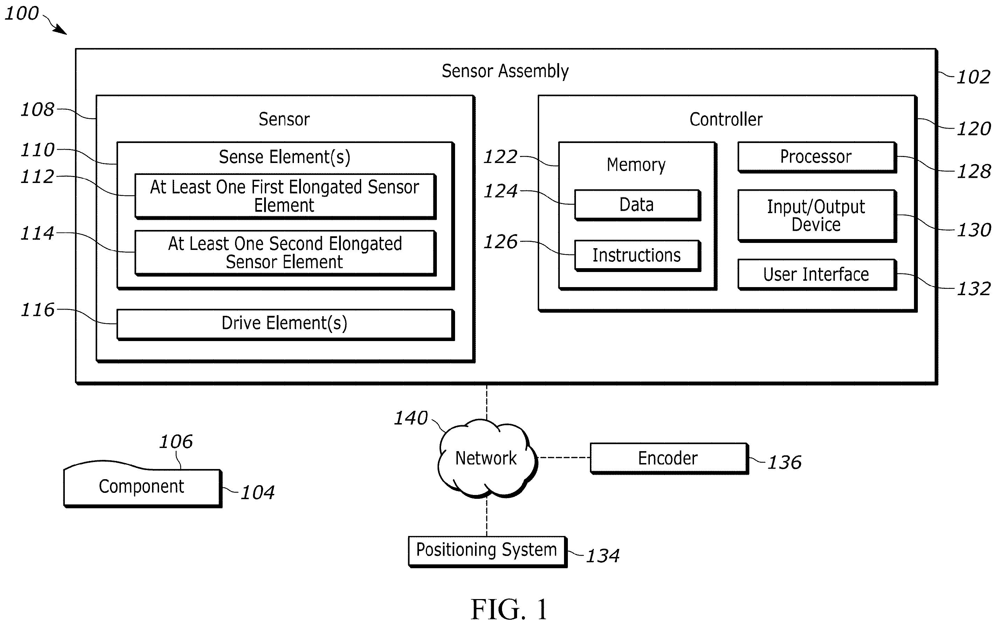

Turning to the figures, FIG. 1 shows a system 100 that includes a sensor assembly 102 in accordance with various embodiments. In some embodiments, the sensor assembly 102 is an eddy current sensor assembly. The sensor assembly 102 can be used to inspect a component 104 having an inspection surface 106 that is complex. The component 104 may be made from a conductive material, such as a metallic material. For example, the component 104 may have a multi-axial curvature or other complex geometries. In some examples, the component 104 is a component of a gas turbine engine such as a turbine blade, shroud, disk, etc. In some configurations, the system 100 further includes a positioning system 134 and, in some aspects, an encoder 136.

The sensor assembly 102 includes a sensor 108 that captures data on the component 104 to be inspected and a controller 120 that is in communication with the sensor 108. The sensor 108 has a plurality of eddy current sensor elements. In one embodiment, the eddy current sensor elements include at least one first elongated sensor element 112, which is elongated in a first direction. The eddy current sensor elements also include at least one second elongated sensor element 114 that is elongated in a second direction, the second direction being at an angle relative to the first direction. The controller 120 may act as a signal processor to process signals from the sensor 108 for defect detection of the component 104 being inspected.

In the illustrated embodiment, the sensor assembly 102 includes one or more sense elements 110 and one or more drive elements 116. The first elongated sensor element 112 and the second elongated sensor element 114 are included in the sense elements 110.

The drive elements 116 can include one or more sensor elements, such as one or more eddy current drive coils. The drive elements 116 can include a variety of sensor elements and arrangements. In some configurations, the drive elements 116 include a plurality of drive coils arranged in an array. In some configurations, the drive elements 116 include a single drive coil. In yet other embodiments, the drive elements 116 include a trace configured in any suitable manner. The drive elements 116 are configured to generate a magnetic field. The magnetic field generated by the sensors elements of the drive elements 116 induces eddy currents in the component 104 when the coil(s) are placed near the surface 106 of the component 104. The drive elements 116 can be made from any suitable conductive material including but not limited to gold, silver, copper, etc. In some configurations, the drive elements 116 include one or more drive coils. The drive coils can be any suitable shape including but not limited to circular coils, rectangular coils, square coils, elliptical coils, or continuous wave shapes with a wave, for example, having a rectangular or semi-circular shape. The drive elements 116 can also have any suitable arrangement. In some examples, the drive elements 116 are arranged in one or more rows. In other examples, the drive elements 116 are arranged in a generally triangular or a generally square pattern.

The drive elements 116 are fabricated on a substrate, such as a thin printed circuit board (PCB) substrate. In some embodiments, the drive elements 116 are formed on a flexible substrate. In some embodiments, the drive elements 116 are formed on a stretchable substrate.

The sense elements 110 can include one or more sensor elements, such as one or more eddy current sense sensor elements. The sense elements 110 can include a variety of sensor elements and arrangements. The sense elements 110 can be coils, magnetoresistive sensors, or combinations thereof. In some configurations, the sense elements 110 include a plurality of sense coils arranged in an array. In other configurations, the sense elements 110 include a single sense coil. In yet other embodiments, the sense elements 110 include a trace configured in any suitable manner (e.g., a meandering trace incorporated around one or more of the drive elements 116). The sense elements 110 are configured to detect the induced eddy current in the component 104. The sense elements 110 can be made from any suitable conductive material including but not limited to gold, silver, copper, etc. The sense elements 110 can include sense coils. The sense coils can be any suitable shape and can including but are not limited to circular coil, rectangular coil, square coil, or elliptical coils. The sense coils in the sense elements 110 can also have any suitable arrangement. In some examples, the elements of sense elements 110 are arranged in one or more rows. In other examples, the elements of the sense elements 110 are arranged in a generally triangular or a generally square pattern.

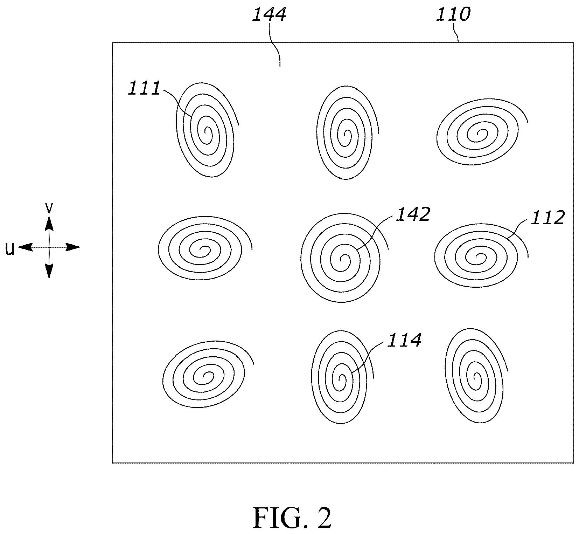

In some embodiments, the sense elements 110 include the at least one first elongated sensor element 112 and the at least one second elongated sensor element 114. The first elongated sensor element 112 is elongated along a first axis. The second elongated sensor element is elongated along a second axis, where the second axis is angled relative to the first axis. In some embodiments, the second axis is substantially perpendicular to the first axis. The at least one first elongated sensor element 112 may include a single sensor element or a plurality of sensor elements. Similarly, the at least one second elongated sensor element 114 can include a single sensor element or a plurality of sensor elements. Elongated sensor elements may refer to sensor elements, such as coils, that are elongated in at least one axis. The elongated sensor elements can be any suitable shape such as, for example, elliptical or rectangular. In some embodiments, the sense elements 110 also includes at least one circular coil. An exemplary configuration for the sense elements 110 is shown in FIG. 2.

The sense elements 110 can be fabricated on a substrate, such as a thin printed circuit board (PCB) substrate. In some embodiments, the sense elements 110 are formed on a flexible substrate. In some embodiments, the sense coil array is formed on a stretchable substrate.

Forming one or more of the drive elements 116 and the sense elements 110 on a stretchable substrate and/or or a flexible substrate may effectively form a stretchable eddy current sensor. The shape of the sensor 108 may stretch to conform to a nonplanar surface with complex geometries.

The controller 120 may function as a computing device to perform any of the functions and methods described herein. The controller 120 can be configured to control electronics to excite elements of the drive elements 116 and to detect or measure the response of the elements in the sense elements 110. For example, the controller 120 may be configured for eddy current inspection of the component 104 using the sensor 108. The controller 120 may be configured to control the flow of current to the coils of the sensor 108, such as to the drive elements 116. The controller 120 may also be able to detect, measure, or receive eddy current inspection data from the sensor 108. Eddy current inspection data can include data related to the change in impedance of the coils of the sensor 108, for example, the impedance of the coils of the sense elements 110, which is directly influenced by the proximity of a component 104 and the resulting eddy currents induced within the component 104. The controller 120 may be configured to identify one or more features or defects in the component 104 based on the eddy current inspection data.

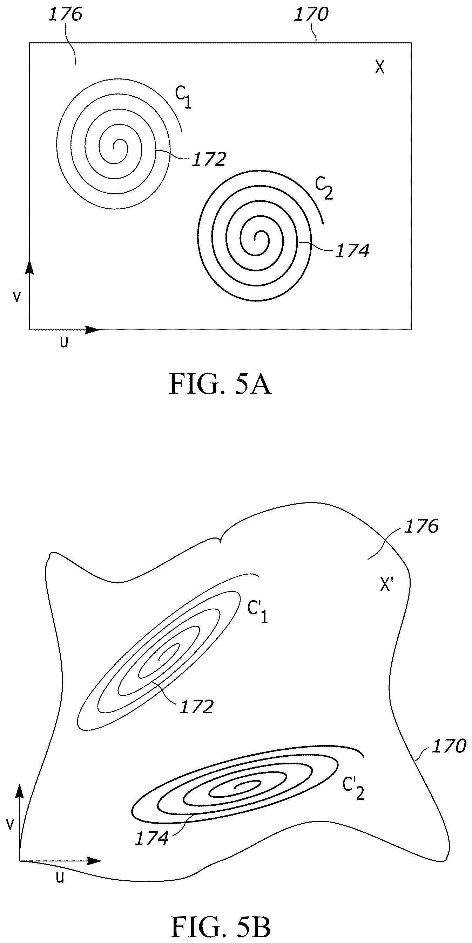

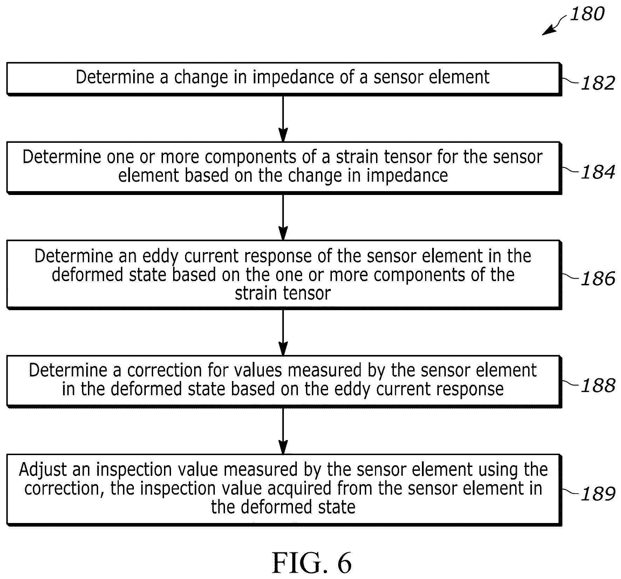

In some embodiments, the controller 120 is configured to determine and apply a correction to signals from the eddy current sensor compensate for sensor deformation (e.g., stretching or compression) that occurs due to contact with the surface 106 of the component 104. The correction may be a gain signal and/or a phase signal that is applied to output signals from the sense elements 110. So configured, the controller 120 is able to compensate for distortions to the sensor 108 to make the signals from the sensor 108 invariant to stretching or deformations. In some embodiments, the controller 120 is configured to perform one or more steps described with reference to FIGS. 5A-5C and 6 herein.

In some embodiments, the controller 120 is configured to determine strain in one or more sensor elements (e.g., coils) of the sensor based on data received from the coils and use the strain to determine the correction. So configured, the controller 120 can be used for both determining a strain in the sensor elements of the sensor 108 and for acquiring inspection data from the coils of the sensor 108. For example, the controller 120 may determine strain (e.g., a strain tensor) for one or more coils of the sensor 108 based on changes in impedance, which is a combination of the changes in resistance and inductance due to deformation in the coils. In an alternate embodiment, impedance changes under constant applied current or voltage can be used. In some embodiments, the excitation waveform can be time division multiplexed in such a way as to enable separating out the impedance changes due to strain by using a constant or different frequency excitation multiplexed with excitation at a different frequency to capture the variations due to the changes in eddy current from discontinuities.

In one example, in a calibration operation, the sensor 108 is intentionally deformed and changes in impedance of the sensor elements due to the deformation are measured. In the calibration operation, a correction for one or more sensor elements of the sensor 108 is determined. Numerical methods and/or machine learning approaches can then be used to determine strain on the sensor elements. The strain can then be used to describe the deformation of the coils. The deformation can then be used to determine a deformed shape which can be used to determine the deformed eddy current and a deformed response in the sense coil. The correction for the sensor elements of the sensor 108 can then be applied to measurements performed by the sensor 108 in an inspection operation. For example, the controller 120 can monitor or determine strain on the sensor elements of the sensor 108 and apply a correction to the sensor elements based on the strain on the sensor elements.

In some embodiments, the controller 120 is configured for health monitoring of the component 104. The sensor 108 can be installed on the surface 106 of the component 104 and left in place for a period of time. The controller 120 may acquire a baseline measurement after the sensor 108 is first installed and then monitor readings from the sensor 108 over time. The controller 120 may determine one or more characteristics and/or defects of the component 104 based on the readings acquired by the sensor 108. In some approaches, the controller 120 is configured to acquire a baseline value for a parameter measured by one or more sensor elements of the sensor 108 and to compare the baseline value to update values measured by the sensor elements. The controller 120 may then identify the characteristics and/or defects in the component 104 by comparing the baseline value to the updated value measured by the sensor elements.

The controller 120 may include one or more processors 128, input/output (I/O) devices 130, and memory devices 122. The processors 128 may include any suitable processing device such as a microprocessor, microcontroller, integrated circuit, logic device, or other suitable processing device. The processors 128 may be used to execute or assist in executing the steps of the processes, methods, functionality, and techniques described herein, and to control various communications, decisions, programs, content, listings, services, interfaces, logging, reporting, etc. Further, the one or more processors 128 may access the memory devices 122, which may store instructions 126, code and the like that are executed by the processors 128 to implement intended functionality.

The memory devices 122 typically include one or more processor-readable and/or computer-readable media accessed by at least the processors 128 and may include volatile and/or nonvolatile media, such as RAM, ROM, EEPROM, flash memory and/or other memory technology. Further, the memory devices 122 are shown as internal to the controller 120; however, the memory devices 122 may be internal, external or a combination of internal and external memory. Similarly, some or all of the memory devices 122 can be internal, external or a combination of internal and external memory of the processors 128. The memory devices 122 may be substantially any relevant memory such as, but not limited to, solid-state storage devices or drives, hard drive, one or more of universal serial bus (USB) stick or drive, flash memory secure digital (SD) card, other memory cards, and other such memory or combinations of two or more of such memory, and some or all of the memory may be distributed at multiple locations over a computer network. The memory devices 122 may store data 124 such as code, software, executables, scripts, data, content, lists, programming, programs, log or history data, engine information, component information, and the like. It is understood that the various components of FIG. 1 may be coupled together via a bus and/or coupled to the controller 120 and/or one or more other components directly. The memory devices 122 store the operational code or set of instructions 126 that is executed by the controller 120 and/or processor 128 to implement the functionality of the system 100 or parts thereof. In some embodiments, the memory devices 122 may also store some or all of the data 124 that may be needed to inspect the component 104.

The I/O devices 130 may be any relevant port or combinations of ports, such as but not limited to USB, Ethernet, or other such ports. The I/O devices 130 may be configured to allow wired and/or wireless communication coupling to external components. For example, the I/O devices 130 may provide wired communication and/or wireless communication (e.g., Wi-Fi, Bluetooth, cellular, RF, and/or other such wireless communication), and in some instances may include any suitable wired and/or wireless interfacing device, circuit and/or connecting device, such as but not limited to one or more transmitters, receivers, transceivers, or combination of two or more of such devices.

The controller 120 includes a user interface 132. The user interface 132 may be used to control one or more components of the system 100. The user interface 132 may be used for user input and/or output display. For example, the user interface 132 may include any known input devices, such as one or more buttons, knobs, selectors, switches, keys, touch input surfaces, audio input, displays, etc. Additionally, the user interface 132 may include one or more output display devices, such as lights, visual indicators, display screens, etc., to convey information to a user, such as but not limited to communication information, status information, notifications, errors, conditions, and/or other such information. Similarly, the user interface 132 in some embodiments may include audio systems that can receive audio commands or requests verbally issued by a user, and/or output audio content, alerts, and the like. In some embodiments, the user interface may include display of the part geometry being scanned by the eddy current sensor and the location of the indication(s) if any, after the inspection is done.

In some embodiments, the system 100 includes a positioning system 134 for adjusting a position of the sensor 108 and/or the component 104. The positioning system 134 is in operative communication with the controller 120. The positioning system 134 is optional and, in some embodiments, the sensor 108 and/or the component 104 may be positioned manually. The positioning system 134 can be configured to adjust the position of the sensor 108 relative to the component 104 and/or to adjust the position of the component 104 relative to the sensor 108. In some examples, the positioning system 134 includes a movable platform, a turntable, or another device that holds and/or is capable of moving the component 104. In some examples, the positioning system 134 includes a device such as a rotation fixture, a robotic arm, an X-Y scanner with a gimbal and/or swivel angle controls, or another device that is operable to move the sensor 108 in a controlled manner along the component 104. In some configurations, the positioning system 134 is two or more separate controllable devices working in conjunction with each other.

In some embodiments, the system 100 includes an encoder 136 to measure the movement of the sensor 108 and correlate eddy current inspection data with a spatial position on the surface 106 of the component 104. The encoder 136 is in communication with the controller 120. In some embodiments, the encoder 136 is part of the sensor assembly 102. The encoder 136 can be any suitable sensing device that provides feedback regarding the position of the sensor 108 relative to the component 104. The encoder 136 can convert motion of the sensor 108 to an electrical signal that is communicated to the controller 120 to determine a position of the sensor 108, for example, on the surface of the component 104. The controller 120 can then associate the eddy current inspection data with the position of the sensor 108. It is also possible to map measurements from individual drive elements 116 and/or the sense elements 110 to positions on surface 106 of the component 104, for example, based on the fixed position of sensor elements within an array and the position information from the controller 120. This may allow for a precise mapping of measurements to specific locations on the surface 106 of the component 104. In some aspects, the controller 120 can assemble a set of inspection data that corresponds with a single pass or scan of the component 104. Examples of suitable encoders include motor encoders, rotary encoders, linear encoders, optical encoders, magnetic encoders, capacitive encoders, etc.

One or more components of the system 100 including the sensor assembly 102, the positioning system 134, and/or the encoder 136 may communicate information to or from one another over a network 140. The network 140 can be any suitable communication network such as, for example, LAN, WAN, Internet, cellular, Wi-Fi, and other such communication networks or combinations of two or more of such networks. The components of the system 100 may also communicate via a wired connection.

The system 100 can be operated in an inspection operation. In the inspection operation, the controller 120 controls the flow of electrical current through the drive elements 116 of the sensor 108. Current flowing through the drive elements 116 creates a magnetic field that induces eddy currents at the surface 106 of the component 104. Characteristics such as variations in material properties and discontinuities (e.g., cracks) in the component 104 can disturb the eddy current trajectories. The sense elements 110 sense or detect changes in the magnetic field caused by the induced eddy currents, allowing the sensor 108 to determine characteristics of the component 104 based on changes in the impedance of the coils in the sense elements 110.

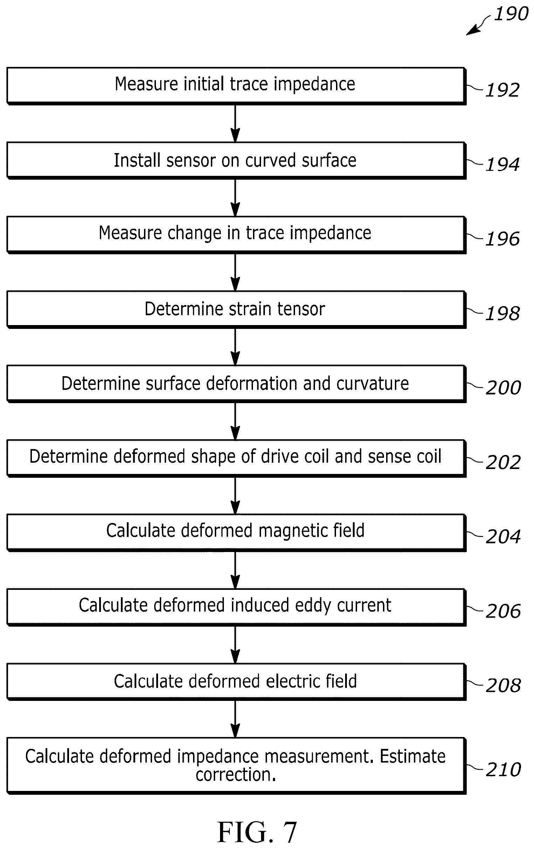

In addition, the system 100 can be operated in a setup or calibration operation. In the calibration or setup operation, the controller 120 can be used to determine a correction for output signals from the sensor 108 that help correct for deformations of the sensor 108 during use. In the calibration mode, the sensor 108 may be subjected to a deformation to cause the coils of the sensor 108 to deform or change shape. During such a deformation, the controller 120 can determine a strain on the sensor elements of the sensor 108 based on changes in the impedance due to the deformation. As described further herein, the controller 120 can use the strain to derive a correction for measurements (e.g., impedance measurements) acquired using the sensor 108. Methods for determining the correction factor, that can be implemented by the controller 120, are shown and described with reference to FIGS. 6 and 7.

FIG. 2 illustrates an exemplary configuration for the sensor elements of the sense elements 110, according to some embodiments. The sense element 110 shown in FIG. 2 is a 3x3 cluster of eddy current sensor elements 111 that are disposed on a substrate 144. In some embodiments, the sensor elements 111 of the sense elements 110 include drive and sense coils. In some embodiments, the substrate 144 is a stretchable substrate. In other embodiments, the substrate 144 is a flexible substrate. The sensor elements 111 are arranged in rows. The sense element 110 includes (8) elongated sensor elements (e.g., coil) and one circular coil 142. The circular coil 142 is disposed at the center of the 3x3 cluster, with the elongated sensor elements arranged around the circular coil 142.

The sense element 110 includes at least one first elongated sensor element 112 and at least one second elongated sensor element 114. The first elongated sensor element 112 is elongated about the first axis u. The second elongated sensor element 114 is elongated along the second axis v, which is disposed substantially perpendicular to the first axis *u.* The sense element 110 includes four first elongated sensor elements 112 that are elongated about the u axis and four second elongated sensor elements 114 that are elongated about the v axis.

Though the sensor elements 111 of the sense element 110 are disposed in rows and columns, it is contemplated that the sensor elements 111 can have any suitable arrangement. In some embodiments, the sensor elements 111 are arranged to suit a particular application, for example, to inspect a particular component geometry.

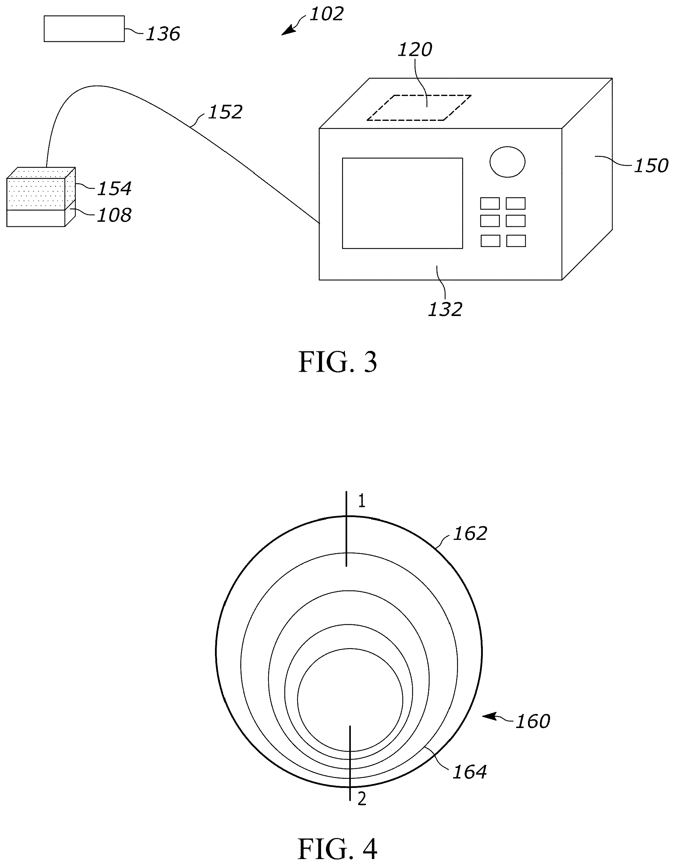

FIG. 3 shows the sensor assembly 102, according to an exemplary embodiment. The sensor assembly 102 includes the sensor 108 coupled to a sensor mount 154. The sensor 108 and sensor mount 154 are coupled to a controller housing 150. The controller housing 150 includes the controller 120 and may also include any suitable electrical components for facilitating operation of the sensor 108. The sensor 108 is coupled to the controller housing 150 via, for example, a cable 152. The controller housing 150 includes the user interface 132. The user interface 132 may include a variety of user inputs that are configured for controlling the operation of the sensor assembly 102. In some examples, the user interface 132 includes one or more buttons, control knobs, and/or touch pads. The user interface 132 may also include one or more graphical displays configured to provide operational feedback or other information to a user of the sensor 108. In the shown embodiment, the sensor assembly 102 further includes the encoder 136.

FIG. 4 shows an exemplary coil 160 of the sensor 108 that is being deformed non uniformly, for example due to contact with the surface 106 of the component 104 (not shown). The coil 160 can correspond to any example of the sensor elements disclosed herein (e.g., the sense elements 110 and/or the drive elements 116 of FIG. 1 or the coils of FIGS. 5A and 5B). The coil 160 includes a first portion 162 and a second portion 164. The first portion 162 of the coil is being stretched to conform to the surface 106, with Line 1 illustrating a stretched area of the coil 160. The second portion 164 of the coil 160 is being compressed to conform to the surface 106, with Line 2 illustrating a compressed area of the coil 160. It is contemplated that the techniques described herein for compensating for distortions in the sensor coils to result in a distortion invariant response can be used to compensate for both compression and stretching of a coil.

FIGS. 5A and 5B show a sensor array 170 being deformed, for example, due to contact with a component 104 having a complex geometry. The sensor array 170 can correspond to any example of the sensor elements disclosed herein (e.g., the sense elements 110 and/or the drive elements 116 of FIG. 1). The sensor array 170 includes a first sensor element 172 (e.g., a first coil) and a second sensor element 174 (e.g., a second coil) that are disposed on a stretchable substrate 176. The first sensor element 172 and the second sensor element 174 are positioned at certain coordinates (*u,v*) on the stretchable substrate 176. The output of the first sensor element 172 and the second sensor element 174 can be used to create a map of the impedance of the sensor array 170.

In FIG. 5A, the sensor array 170 is in an undeformed state. The undeformed state may refer to the natural or resting state of the sensor array 170 (and the sensor elements therein) without external forces acting thereon. In the undeformed state, the stretchable substrate 176 has an undeformed sensor shape (X). In the undeformed state, the first sensor element 172 has an undeformed shape C₁ and the second sensor element 174 has an undeformed shape C₂. In the undeformed state, the first sensor element 172 has an initial impedance (Z₁) and the second sensor element 174 has an initial impedance (Z₂).

In FIG. 5B, the sensor array 170 is in a deformed state, which may occur when the sensor array 170 is applied to a surface 106 having a complex geometry. In the deformed state, the stretchable substrate 176 has a deformed sensor shape (X'). In the deformed state, the first sensor element 172 has a deformed shape C'₁ and the second sensor element 174 has a deformed shape C'₂. As shown, the first sensor element 172 and the second sensor element 174 have been stretched relative to their initial positions in FIG. 5A, resulting in distortion and elongation of their initial, undeformed shapes. In the deformed state, the first sensor element 172 has a new impedance (Z'₁) and the second sensor element 174 has a new impedance (Z'₂).

The methods and systems described herein can be used to determine local strain for each individual coil in a sensor array, such as the sensor array 170, and corresponding corrections applied to each individual coil based on the local strains. For example, a first gain signal can be determined as a correction for the first sensor element 172. In one example, the excitation waveform for a coil can be time division multiplexed in such a way as to enable separating out the impedance changes due to strain by using a constant or different frequency excitation multiplexed with excitation at a different frequency to capture the variations due the changes in eddy current from discontinuities. The first gain signal is applied to the output signal from the first sensor element 172. Likewise, a second gain signal can be determined as a correction for the second sensor element 174 and applied to the output signal from the second sensor element 174.

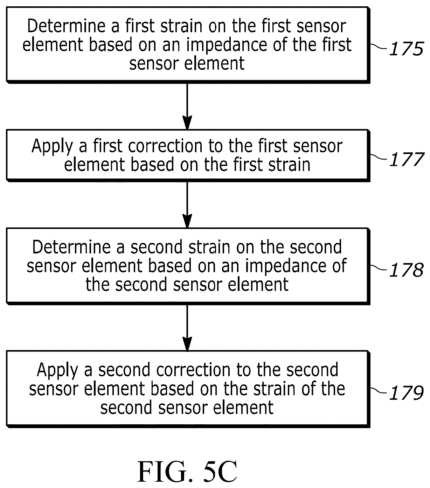

FIG. 5C illustrates a method for correcting readings from the sensor array 170 of FIGS. 5A and 5B to compensate for variations in sensor readings due to the stretching and/or deformation of the sensor array 170. The method may help to mitigate sensor deformation effects. The method can be used to apply corrections to individual sensor elements 172, 174 in the sensor array 170 depending on the particular strains experienced by the individual sensor elements 172, 174 in the sensor array 170. The method of FIG. 5C or portions thereof can be performed or implemented using the controller 120 of FIG. 1. For example, the controller 120 can be configured to perform the method or portions thereof.

At 175, a first strain on the first sensor element (C₁') is determined based on an impedance of the first sensor element 172. At 177, a first correction is applied to the first sensor element 172 based on the first strain. In some embodiments, the first correction for the first sensor element 172 is a first gain signal applied to an output signal of the first sensor element 172.

At 178, a second strain on the second sensor element 174 is determined based on an impedance of the second sensor element 174. At 179, the method includes applying a second correction to the second sensor element 174 based on the strain of the second sensor element 174. In some embodiments, the second correction for the second sensor element 174 is a second gain signal applied to an output signal of the second sensor element 174. The first and second corrections may be different.

Though the method of FIG. 5C is described with reference to a sensor array with two sensor elements (e.g., two coils), it is contemplated that the method can be applied to a sensor element with any number of coils. In some embodiments, in addition to using the strain measurements from the coil elements, the component geometry information from a CAD model of the component along with the position information of the sensor array can be used to determine the deformation of the different elements in the sensor array.

FIG. 6 illustrates a method 180 for determining corrections for measurements acquired by sensor elements of a stretchable sensor, such as a stretchable eddy current sensor. In some embodiments, the method 180 is used to determine corrections to calibrate the sensor 108 of FIG. 1. In some embodiments, the method 180 or portions thereof are implemented by the controller 120. For example, the controller 120 may be configured to perform the method 180 or portions thereof.

At 182, a change in impedance of a sensor element is determined. The change in impedance results from deformation of the sensor element. The sensor element may be a coil, such as a sense coil or a drive coil. In some examples, the sensor element is a sensor element of the sense elements 110 or the drive elements 116 in the sensor 108 of FIG. 1. The change in impedance may result from a deformation of the sensor element due to an external force. In some examples, the external force is due to contact of a sensor assembly with a component during an inspection. In some aspects, the sensor assembly includes a plurality of sensor elements and the change in impedance is measured for each sensor element.

Exposure to an external force can cause the sensor element to change from an undeformed state to a deformed state. In the undeformed state, the sensor element has an initial impedance, and the sensor element has an undeformed shape. In a deformed state, the sensor element has a final impedance, and the sensor element has a deformed shape. The change in impedance can be determined by measuring the initial impedance of the sensor element representing impedance before deformation (e.g., in the undeformed state), measuring the final impedance of the sensor element representing impedance after deformation (e.g., in the deformed state), and determining the difference between the initial impedance and the final impedance. The difference between the initial and final impedance represent the change in impedance.

In some approaches, time division multiplexing is used to separate measurements of resistance and inductance from the sensor element. Time division multiplexing involves performing measurements of resistance and inductance sequentially within fixed or dynamically allocated time slots. For example, a period of time may be divided into distinct time slots and in each slot, a different measurement type (e.g., resistance, inductance, etc.) is measured. During a dedicated time slot, the sensor 108 may apply a direct current (DC) to the sensor element to excite the sensor element at a low frequency and measure the resulting current to determine resistance. During a dedicated, separate time slot, the sensor 108 may apply an alternating current (AC) to the sensor element to excite the sensor element at a high frequency and measure the resulting current and phase difference to determine inductance. Impedance can be measured in both time slots. For example, impedance can be determined via the expression impedance (Z) = R + jX, where R represents the real part of impedance which is the resistance (R), j is the imaginary unit representing the square root of -1, and X represents the imaginary part of impedance from the inductance of the coil.

The frequency content within each time slot can be adjusted in any suitable manner. In some approaches, time division can be used with two or more frequencies in different time slots. In some approaches, a sensor element can be excited with a chirp excitation in one or more time slots. Eddy current sensors detect changes in impedance, which is a combination of resistance (R), and inductance (L). Resistance changes with strain. By adjusting the frequency content in each time slot, the system can isolate the effects of strain and signal variation from defects.

At 184, a strain on the coil is determined based on the change in impedance. The strain on the sensor element can be represented as a strain tensor. In some approaches, one or more components of the strain tensor for the sensor element are determined based on the change in impedance. A relationship exists between the change in impedance and the strain on the sensor element. The strain tensor can therefore be determined based on the change in impedance. The strain tensor may represent or describe the deformation of the sensor element, for example, at a given point of the sensor element. It is contemplated that other parameters indicative of strain may be determined based on the change in impedance.

At 186, an eddy current response of the sensor element in the deformed state is determined based on the one or more components of the strain tensor. The eddy current response can include an eddy current parameter that can be measured or determined using the eddy current sensor element. In some embodiments, the eddy current response can be an impedance measurement of the sensor element.

In some embodiments, a shape of the sensor element in the deformed state is determined based on the change in impedance. The shape of the sensor element in the deformed state can be determined based on at least one of a deformation or a curvature of the sensor element in the deformed state, with information about the component geometry, and with an encoder that gives information on the location of the sensor element on the component at any point in time. The curvature of the sensor element in the deformed state may be based on a metric tensor for the sensor element in the deformed state. The deformation and/or the curvature of the sensor element in the deformed state can be determined using component(s) of the strain tensor. The eddy current response can then be determined based on the shape of the sensor element in the deformed state. For example, an induced eddy current of the sensor element in the deformed state can be determined based on the shape of the sensor element in the deformed state.

Machine learning can be used to assist with determining one or more aspects of the eddy current response of the sensor element in the deformed state. One or more equations relating to differential geometry of the sensor element and/or conservation laws can be used to reduce the dimensionality of the problems for machine learning to a physically admissible subspace. The use of equations relating to differential geometry and/or conservation laws drastically reduces the need for training data and training time. For example, a small number of calibration sensor elements can be printed on a sensor to adequately characterize complex curvatures. The impedance changes on a small number of calibration sensor elements can be used for training, as well as the shape of the sensor elements in the undeformed and deformed states.

In some embodiments, the curvature of the sensor element in the deformed state is determined using a curvature machine learning algorithm. The curvature machine learning algorithm can be trained on a plurality of known curvatures associated with known strain tensor components.

In some embodiments, the metric tensor for the sensor element in the deformed state is determined using a metric tensor machine learning algorithm. The metric tensor machine learning algorithm can be trained on a plurality of known metric tensors for known coil shapes.

In some embodiments, the characteristic of the magnetic field in the deformed state is determined using a magnetic field machine learning algorithm. The magnetic field machine learning algorithm can be trained on a plurality of known magnetic fields resulting from known deformed coil shapes.

In some embodiments, one or more components of the strain tensor are determined using a strain machine learning algorithm. The strain machine learning algorithm can be trained on a plurality of known coil strains associated with known changes in impedances.

At 188, a correction factor for values measured by the sensor element in the deformed state is determined. In some approaches, the correction factor is determined based on the eddy current response of the sensor element in the deformed state. In some embodiments, the correction is based on the impedance measurement for the coil in the deformed state, as determined, for example, at 186. In some implementations, the correction is a gain signal that is applied to output signals of the sensor element (e.g., a sense coil) of the stretchable eddy current sensor.

At 189, an inspection value measured by the sensor element is adjusted using the correction. The inspection value is a value measured by the sensor element while the sensor element is in the deformed state. In the deformed state, the sensor element is subjected to a certain strain and the correction adjusts the value measured by the sensor element based on the strain. As described herein, the sensor element can act as a strain sensor. Strain can be determined based on change in impedance experienced by the sensor element due to the deformation. Thus, corrections for the sensor element can be associated with various strain values as part of the calibration method. According, a correction can be applied to values measured using the sensor element based on the strain that is measured or determined using the sensor element.

In some approaches, the correction is applied to a signal of the sensor element to account for deformation of the sensor element. The correction may be applied to signals, for example, from a sensor element of a sense array of the stretchable eddy current sensor to ensure that sensor measurements are deformation invariant. The correction can be used to make a signal from the stretchable sensor invariant of deformation. In some examples, the correction is implemented as a gain signal relative to the impedance measurement in the deformed state. The gain signal can be applied to an output signal of the sensor elements of a sense array in the eddy current sensor.

FIG. 7 illustrates a detailed method 190 for determining corrections for measurements acquired by coils of a stretchable sensor, such as a stretchable eddy current sensor, according to some embodiments. In some embodiments, the method 190 is used to adjust measurements acquired by the sensor 108 of FIG. 1. In some embodiments, the method 190 or portions thereof are implemented by the controller 120. For example, the controller 120 may be configured to perform the method 190.

Blocks 192-196 include aspects of the method 180 that involve physical measurements taken using the stretchable sensor. At 192, an initial trace impedance for a trace of a stretchable sensor is measured. At 194, the stretchable sensor is installed on a curved surface thereby deforming the stretchable sensor to change the stretchable sensor from an undeformed state (see FIG. 5A) to a deformed state (see FIG. 5B). At 196, the change in trace impedance due to the deformation is measured.

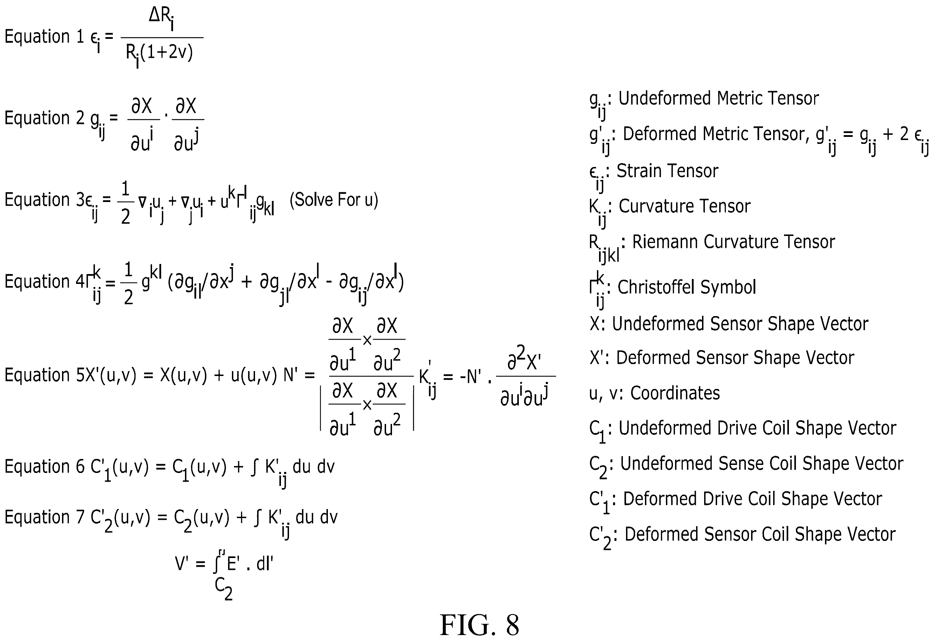

Blocks 198-200 include aspects of the method that involve inverse methods, estimate, optimization, artificial intelligence (Al)/machine learning (ML) or combinations thereof. At 198, a strain tensor is determined. The strain tensor can be determined using Equation 1, Equation 2, Equation 3, and Equation 4 of FIG. 8. At 200, the surface deformation and curvature are determined for the stretchable sensor in the deformed state. The deformation and curvature can be determined using Equation 5 of FIG. 8.

Blocks 202-210 include aspects of the method 190 that involve numerical methods such as reduced order or finite element. At 202, the deformed shape of the coils of the stretchable sensor (e.g., a drive coil and a sense coil such as the first coil and the second coil of the sensor array 170) is determined. The deformed shape of the coils can be determined using Equation 6 and Equation 7 of FIG. 8. A deformed magnetic field may be determined for the coil in the deformed state. The Biot-Savart Law can be used to determine the deformed magnetic field, for example, based on the deformed shape. At 206, a deformed induced eddy current is determined. The deformed induced eddy current in the component being inspected can be determined based on Faraday's Law and/or Ohm's Law. At 208, a deformed electric field is determined. The deformed electric field may be determined based on, for example, Gauss's Law, Farraday's Law and/or Ohm's Law. At 210, a deformed impedance measurement for the stretchable sensor is determined. A correction can be determined or estimated based on the deformed impedance measurement.

In some embodiments, machine learning can be used to determine one or more parameters used in the method 190. In addition, use of differential geometry and conservation laws can reduce the dimensionality of the problem manifold to a physically admissible subspace. This drastically reduces the need for training data and training time, improves accuracy, and prevents overfitting. A small number of calibration traces can be printed on the sensor and will adequately characterize complex curvatures. Physics formulation also allows augmentation with synthetic datasets generated from simulation. In some embodiments, measured data used for determining the correction can include one or more of: changes in impedance in a number of traces due to deformation; changes in phase of the eddy current signals; and undeformed and deformed configurations of the traces and component geometry information. In some embodiments, when machine learning is used, training data can include one or more of: impedance measurements (including phase); strain tensor components from the change in impedance; undeformed and deformed metric tensors for the coils; initial and deformed curvature tensors for the traces; and component geometry information.

FIG. 8 shows example equations that can be used to determine corrections for measurements acquired by coils of a stretchable eddy current sensor. The equations are applied and referenced throughout the description of the method 190 of FIG. 7. For illustrative purposes, the equations include certain variables that are shown and described with reference to the sensor array 170 are shown in FIGS. 5A and 5B.

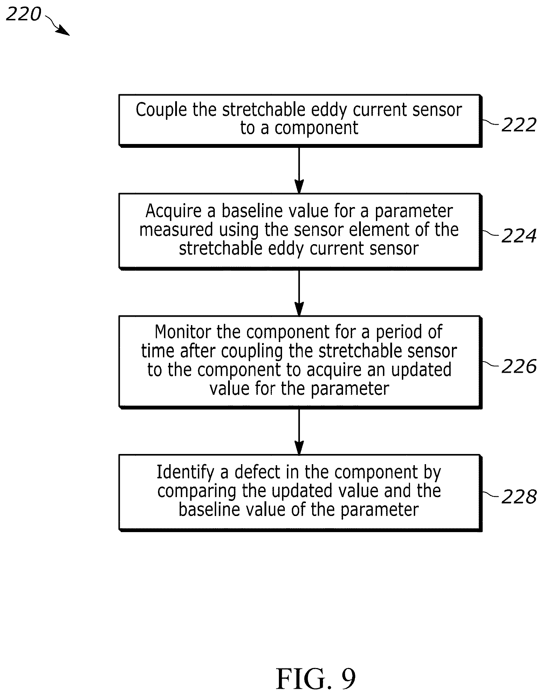

FIG. 9 illustrates an exemplary method 220 for operating a stretchable eddy current sensor for health monitoring of a component. In the method 220, the stretchable eddy current sensor is installed on a component and left in place for health monitoring of the component. Rather than moving the sensor along the surface of the component, the sensor is left in a fixed position on the component (e.g., on the surface of the component). During installation, the sensor may be subjected to an initial deformation or distortion that causes sensor elements of the sensor to assume a deformed shape. Deviations from this initial deformed shape can be monitored, for example, to determine changes in the condition of the component, such as the emergence of defects.

At 222, the stretchable eddy current sensor is coupled to or installed on a component to be monitored. Coupling the stretchable eddy current sensor to the component may result in a sensor element of the eddy current sensor having an initial deformed shape. In some aspects, the stretchable eddy current sensor is the sensor 108 that is shown and described with reference to FIG. 1. The component can be any component and, in some examples, is a component having a complex geometry. Thus, the stretchable eddy current sensor may be bent, stretched, or deformed in any suitable manner to couple the stretchable eddy current sensor with a surface of the component. In one example, the stretchable eddy current sensor is wrapped around a portion of the component.

At 224, a baseline value for a parameter measured using the sensor element of the stretchable eddy current sensor is acquired. The baseline value may be acquired from the sensor element at a first time. In some examples, the first time is after the sensor is installed on the component and before the component is used or placed into service. Thus, the baseline value may represent a reading or measurement acquired by the sensor element when the component is in an initial condition. In addition, the baseline value is acquired when the sensor element has the initial deformed shape.

At 226, the component is monitored for a period of time using the sensor element. During the monitoring, an updated value for the parameter measured using the sensor element of the stretchable eddy current sensor is acquired. The component may be monitored for any suitable amount of time. In one example, the component is monitored for a period of time while the component is in service, use, or operation.

At 228, a defect and/or a characteristic of the component is identified by comparing the updated value of the parameter to the baseline value of the parameter. Deviations from the baseline value that is measured using the sensor element may indicate that a defect is present in the component. For example, a crack may cause a spike in the amplitude of the impedance value that is measured or monitored using the sensor element of the stretchable eddy current sensor.

In some embodiments, the method 220 further includes determining a correction for the sensor element of the stretchable eddy current sensor in the initial deformed shape. Any of the approaches described herein can be used to determine the correction. The correction may be used to calibrate the sensor element to compensate for the initial deformation when installing the sensor on the component. Thus, the method 220 may also further include applying the correction to the baseline value and the updated value for the parameter measured by the stretchable eddy current sensor. Because there is a single initial deformation to couple the sensor to the component, the correction may be a one-time correction versus a real time correction, for example, which may be used during a scan of the part using the sensor.

It is contemplated that the stretchable eddy current sensors and methods described herein can be used to dynamically compensate for strain on the stretchable sensor. For example, strain on the stretchable sensor may change dynamically as the sensor is moved across a complex surface. The methods described herein, such as the method 180 of FIG. 6 or the method 190 of FIG. 7 can be used to adjust or correct readings from coils of the stretchable sensor based on the strain on the coil as the strain on the coil changes during an inspection.

In some embodiments, the correction is implemented using the controller 120. In this manner, the controller 120 acts as a signal filter to compensate for the variation in the parameter due to the initial deformed shape.

Further aspects of the disclosure are provided by the subject matter of the following clauses:
A stretchable eddy current sensor comprising: a stretchable substrate; and an eddy current sensor element array comprising a plurality of sensor elements disposed on the stretchable substrate, the plurality of sensor elements including at least one drive element and at least one sense element.

The stretchable eddy current sensor of any preceding clause, wherein the eddy current sensor element array includes: at least one first sensor element that is elongated along a first axis; and at least one second sensor element that is elongated along a second axis, wherein the second axis is angled relative to the first axis.

The stretchable eddy current sensor of any preceding clause, wherein the second axis is substantially perpendicular to the first axis.

The stretchable eddy current sensor of any preceding clause, wherein the eddy current sensor element array includes at least one circular coil.

The stretchable eddy current sensor of any preceding clause, wherein the at least one sense element includes a coil or a magnetoresistive sensor.

The stretchable eddy current sensor of any preceding clause, wherein the eddy current sensor element array includes sense coils.

The stretchable eddy current sensor of any preceding clause, wherein the eddy current sensor element array includes drive coils.

The stretchable eddy current sensor of any preceding clause, wherein the plurality of sensor elements includes at least one of a circular coil, a rectangular coil, an elliptical coil, a square coil, or a continuous wave shaped coil.

The stretchable eddy current sensor of any preceding clause, wherein the plurality of sensor elements of the eddy current sensor element array are in communication with a controller, and wherein, for one or more of the plurality of sensor elements, the controller is configured to determine a strain for a sensor element to determine a correction for the sensor element and determine a value for a parameter measured using the sensor element to perform an inspection.

A method of calibrating a stretchable eddy current sensor to account for variations in an eddy current response of the stretchable eddy current sensor due to deformations, the method comprising: determining a change in impedance of a sensor element of the stretchable eddy current sensor, the change in impedance representing a difference in impedance of the sensor element in a deformed state and an undeformed state; determining one or more components of a strain tensor for the sensor element based on the change in impedance; determining an eddy current response of the sensor element in the deformed state based on the one or more components of the strain tensor; and determining a correction for values measured by the sensor element in the deformed state based on the eddy current response.

The method of any preceding clause, wherein the eddy current response includes at least one of an impedance measurement or a voltage measurement of the sensor element in the deformed state.

The method of any preceding clause, further comprising: measuring an initial impedance for the sensor element, the initial impedance representing impedance of the sensor element in the undeformed state; measuring a final impedance for the sensor element, the final impedance representing impedance of the sensor element in the deformed state; and determining a difference between the initial impedance and the final impedance, the difference representing the change in impedance.

The method of any preceding clause, further comprising: determining a shape of the sensor element in the deformed state based on the change in impedance, wherein the eddy current response is determined based on the shape.

The method of any preceding clause, further comprising: determining at least one of a deformation or a curvature for the sensor element in the deformed state based on the one or more components of the strain tensor, wherein the shape of the sensor element in the deformed state is determined based on at least one of the deformation or the curvature of the sensor element.

The method of any preceding clause, further comprising: determining at least one of a deformation or a curvature for the sensor element in the deformed state based on the one or more components of the strain tensor, wherein the shape of the sensor element in the deformed state is determined based on geometry information of a component being inspected and position information indicating a position of the stretchable eddy current sensor on the component.

The method of any preceding clause, wherein the curvature for the sensor element in the deformed state is determined using a curvature machine learning algorithm that is trained on a plurality of known curvatures associated with known strain tensor components.

The method of any preceding clause, wherein the curvature for the sensor element is based on a metric tensor for the sensor element in the deformed state.

The method of any preceding clause, wherein the metric tensor for the sensor element in the deformed state is determined using a metric tensor machine learning algorithm that is trained on a plurality of known metric tensors for known sensor element shapes.

The method of any preceding clause, further comprising: determining an induced eddy current of the sensor element in the deformed state based on the shape of the sensor element in the deformed state; and determining an impedance measurement for the sensor element in the deformed state based on the induced eddy current, wherein the correction is based on the impedance measurement for the sensor element in the deformed state.

The method of any preceding clause, further comprising: determining a characteristic of a magnetic field of the sensor element in the deformed state based on the shape of the sensor element in the deformed state, wherein the induced eddy current of the sensor element is determined based on the characteristic of the magnetic field.

The method of any preceding clause, further comprising: adjusting an inspection value measured by the sensor element using the correction, wherein the correction is implemented using a signal filter.

The method of any preceding clause, wherein the one or more components of the strain tensor are determined using a strain machine learning algorithm that is trained on a plurality of known sensor element strains associated with known changes in impedances.

The method of any preceding clause, further comprising: adjusting an inspection value measured by the sensor element using the correction, the inspection value acquired from the sensor element in the deformed state.

The method of any preceding clause, wherein the correction is a gain signal and/or a phase signal that is applied to output signals from the sensor element of the stretchable eddy current sensor.

A method of operating a stretchable eddy current sensor for health monitoring of a component, the method comprising: coupling the stretchable eddy current sensor to a component, the coupling resulting in a sensor element of the stretchable eddy current sensor having an initial deformed shape; acquiring a baseline value for a parameter measured using the sensor element of the stretchable eddy current sensor, the baseline value acquired from the sensor element at a first time with the sensor element in the initial deformed shape; monitoring the component for a period of time using the sensor element to acquire an updated value for the parameter measured using the sensor element of the stretchable eddy current sensor; and identifying a defect in the component by comparing the updated value and the baseline value of the parameter measured using the sensor element.

The method of any preceding clause, further comprising: determining a correction for the sensor element in the initial deformed shape; and applying the correction to the updated value for the parameter.

The method of any preceding clause, wherein the correction is implemented using a signal filter to compensate for variation in the parameter due to the initial deformed shape.

A method of operating a stretchable eddy current sensor to mitigate sensor deformation effects, the stretchable eddy current sensor comprising a first sensor element, the method comprising: determining a first strain on the first sensor element based on a impedance of the first sensor element; and applying a first correction to the first sensor element based on the first strain.

The method of any preceding clause, wherein the stretchable eddy current sensor includes an eddy current sensor element array including the first sensor element and a second sensor element, and wherein the method further includes determining a second strain on the second sensor element based on a impedance of the second sensor element; and applying a second correction to the second sensor element based on the second strain.

The method of any preceding clause, wherein the first correction is a first gain and/or phase signal applied to an output signal of the first sensor element, and wherein the second correction is a second gain and/or phase signal applied to an output signal of the second sensor element.

The method of any preceding clause, wherein determining the first correction includes: determining a change in impedance of the first sensor element, the change in impedance representing a difference in impedance of the first sensor element in a deformed state and an undeformed state; determining one or more components of a strain tensor for the first sensor element based on the change in impedance; determining an eddy current response of the first sensor element in the deformed state based on the one or more components of the strain tensor; and determining the first correction based on the eddy current response.

The method of any preceding clause, wherein the eddy current response includes at least one of a magnetic field, an induced eddy current, or an impedance measurement of the first sensor element in the deformed state.

The method of any preceding clause, further comprising: measuring an initial impedance for the first sensor element, the initial impedance representing impedance of the first sensor element in the undeformed state; measuring a final impedance for the first sensor element, the final impedance representing impedance of the first sensor element in the deformed state; and determining a difference between the initial impedance and the final impedance, the difference representing the change in impedance.

The method of any preceding clause, further comprising: determining a shape of the first sensor element in the deformed state based on the change in impedance, wherein the eddy current response is determined based on the shape.

The method of any preceding clause, further comprising: determining at least one of a deformation or a curvature for the first sensor element in the deformed state based on the one or more components of the strain tensor, wherein the shape of the first sensor element in the deformed state is determined based on at least one of the deformation or the curvature of the first sensor element.

The method of any preceding clause, further comprising: determining at least one of a deformation or a curvature for the first sensor element in the deformed state based on the one or more components of the strain tensor, wherein the shape of the first sensor element in the deformed state is determined based on geometry information of a component being inspected and position information indicating a position of the stretchable eddy current sensor on the component.

The method of any preceding clause, wherein the curvature for the first sensor element in the deformed state is determined using a curvature machine learning algorithm that is trained on a plurality of known curvatures associated with known strain tensor components.

The method of any preceding clause, wherein the curvature for the first sensor element is based on a metric tensor for the first sensor element in the deformed state, and wherein the metric tensor for the first sensor element in the deformed state is determined using a metric tensor machine learning algorithm that is trained on a plurality of known metric tensors for known sensor element shapes.

The method of any preceding clause, further comprising: determining an induced eddy current of the first sensor element in the deformed state based on the shape of the first sensor element in the deformed state; and determining an impedance measurement for the first sensor element in the deformed state based on the induced eddy current, wherein the first correction is based on the impedance measurement for the first sensor element in the deformed state.

The method of any preceding clause, further comprising: determining a characteristic of a magnetic field of the first sensor element in the deformed state based on the shape of the first sensor element in the deformed state, wherein the induced eddy current of the first sensor element is determined based on the characteristic of the magnetic field.

The method of any preceding clause, wherein the one or more components of the strain tensor are determined using a strain machine learning algorithm that is trained on a plurality of known sensor element strains associated with known changes in impedances.

A system comprising: a stretchable eddy current sensor comprising: a stretchable substrate; and an eddy current sensor element array comprising a plurality of sensor elements disposed on the stretchable substrate, the plurality of sensor elements including at least one drive element and at least one sense element.

The system of any preceding clause, wherein the eddy current sensor element array includes: a first sensor element that is elongated along a first axis; and a second sensor element that is elongated along a second axis, wherein the second axis is angled relative to the first axis.

The system of any preceding clause, wherein the at least one sense element includes a coil or a magnetoresistive sensor, and wherein the coil is a circular coil, a rectangular coil, an elliptical coil, a square coil, or a continuous wave shaped coil.

The system of any preceding clause, further comprising: a controller in communication with the stretchable eddy current sensor, wherein the controller is configured to: determine a first strain for a first sensor element of the plurality of sensor elements to determine a first correction for the first sensor element; and determine a value for a parameter measured using the first sensor element to perform an inspection.

The system of any preceding clause, wherein the controller is further configured to: determine the first strain on the first sensor element based on an impedance of the first sensor element; and apply the first correction to the first sensor element based on the first strain.

The system of any preceding clause, wherein the controller is further configured to: determine a second strain on a second sensor element of the plurality of sensor elements based on an impedance of the second sensor element; and apply a second correction to the second sensor element based on the second strain.

The system of any preceding clause, wherein the first correction is a first gain and/or phase signal applied to an output signal of the first sensor element, and wherein the second correction is a second gain and/or phase signal applied to an output signal of the second sensor element.

The system of any preceding clause, wherein the controller is further configured to: determine a change in impedance of the first sensor element, the change in impedance representing a difference in impedance of the first sensor element in a deformed state and an undeformed state; determine one or more components of a strain tensor for the first sensor element based on the change in impedance; determine an eddy current response of the first sensor element in the deformed state based on the one or more components of the strain tensor; and determine the first correction based on the eddy current response.

The system of any preceding clause, wherein the eddy current response includes at least one of a magnetic field, an induced eddy current, or an impedance measurement of the first sensor element in the deformed state.

The system of any preceding clause, wherein the controller is further configured to: measure an initial impedance for the first sensor element, the initial impedance representing impedance of the first sensor element in the undeformed state; measure a final impedance for the first sensor element, the final impedance representing impedance of the first sensor element in the deformed state; and determine a difference between the initial impedance and the final impedance, the difference representing the change in impedance.

The system of any preceding clause, wherein the controller is further configured to: determine a shape of the first sensor element in the deformed state based on the change in impedance; and determine the eddy current response based on the shape.

The system of any preceding clause, wherein the controller is further configured to: determine at least one of a deformation or a curvature for the first sensor element in the deformed state based on the one or more components of the strain tensor; and determine the shape of the first sensor element in the deformed state based on at least one of the deformation or the curvature of the first sensor element.

The system of any preceding clause, wherein the controller is further configured to: determine at least one of a deformation or a curvature for the first sensor element in the deformed state based on the one or more components of the strain tensor; and determine the shape of the first sensor element in the deformed state based on geometry information of a component being inspected and position information indicating a position of the stretchable eddy current sensor on the component.

The system of any preceding clause, wherein the controller is further configured to: determine the curvature for the first sensor element in the deformed state is based on a curvature machine learning algorithm that is trained on a plurality of known curvatures associated with known strain tensor components.

The system of any preceding clause, wherein the controller is further configured to: determine the curvature for the first sensor element is based on a metric tensor for the first sensor element in the deformed state; and determine the metric tensor for the first sensor element in the deformed state based on a metric tensor machine learning algorithm that is trained on a plurality of known metric tensors for known sensor element shapes.

The system of any preceding clause, wherein the controller is further configured to: determine an induced eddy current of the first sensor element in the deformed state based on the shape of the first sensor element in the deformed state; determine an impedance measurement for the first sensor element in the deformed state based on the induced eddy current; and determine the first correction is based on the impedance measurement for the first sensor element in the deformed state.

The system of any preceding clause, wherein the controller is configured to: determine a characteristic of a magnetic field of the first sensor element in the deformed state based on the shape of the first sensor element in the deformed state; and determine the induced eddy current of the first sensor element based on the characteristic of the magnetic field.

The system of any preceding clause, wherein the controller is further configured to: determine the one or more components of the strain tensor based on a strain machine learning algorithm that is trained on a plurality of known sensor element strains associated with known changes in impedances.

A system comprising: a stretchable eddy current sensor comprising: a stretchable substrate; and an eddy current sensor element array comprising a plurality of sensor elements disposed on the stretchable substrate, the plurality of sensor elements including at least one drive element and at least one sense element.

The system of any preceding clause, wherein the eddy current sensor element array includes: a first sensor element that is elongated along a first axis; and a second sensor element that is elongated along a second axis, wherein the second axis is angled relative to the first axis.

The system of any preceding clause, wherein the at least one sense element includes a coil or a magnetoresistive sensor, and wherein the coil is a circular coil, a rectangular coil, an elliptical coil, a square coil, or a continuous wave shaped coil.

The system of any preceding clause, further comprising: a controller in communication with the stretchable eddy current sensor, wherein the controller is configured to: determine a first strain for a first sensor element of the plurality of sensor elements to determine a first correction for the first sensor element; and determine a value for a parameter measured using the first sensor element to perform an inspection.

The system of any preceding clause, wherein the controller is further configured to: determine the first strain on the first sensor element based on an impedance of the first sensor element; and apply the first correction to the first sensor element based on the first strain.

The system of any preceding clause, wherein the controller is further configured to: determine a second strain on a second sensor element of the plurality of sensor elements based on an impedance of the second sensor element; and apply a second correction to the second sensor element based on the second strain.

The system of any preceding clause, wherein the first correction is a first gain and/or phase signal applied to an output signal of the first sensor element, and wherein the second correction is a second gain and/or phase signal applied to an output signal of the second sensor element.

The system of any preceding clause, wherein the controller is further configured to: determine a change in impedance of the first sensor element, the change in impedance representing a difference in impedance of the first sensor element in a deformed state and an undeformed state; determine one or more components of a strain tensor for the first sensor element based on the change in impedance; determine an eddy current response of the first sensor element in the deformed state based on the one or more components of the strain tensor; and determine the first correction based on the eddy current response.

The system of any preceding clause, wherein the eddy current response includes at least one of a magnetic field, an induced eddy current, or an impedance measurement of the first sensor element in the deformed state.

The system of any preceding clause, wherein the controller is further configured to: measure an initial impedance for the first sensor element, the initial impedance representing impedance of the first sensor element in the undeformed state; measure a final impedance for the first sensor element, the initial impedance representing impedance of the first sensor element in the deformed state; and determine a difference between the initial impedance and the final impedance, the difference representing the change in impedance.

The system of any preceding clause, wherein the controller is further configured to: determine a shape of the first sensor element in the deformed state based on the change in impedance; and determine the eddy current response based on the shape.

The system of any preceding clause, wherein the controller is further configured to: determine at least one of a deformation or a curvature for the first sensor element in the deformed state based on the one or more components of the strain tensor; and determine the shape of the first sensor element in the deformed state based on at least one of the deformation or the curvature of the first sensor element.

The system of any preceding clause, wherein the controller is further configured to: determine at least one of a deformation or a curvature for the first sensor element in the deformed state based on the one or more components of the strain tensor; and determine the shape of the first sensor element in the deformed state based on geometry information of a component being inspected and position information indicating a position of the stretchable eddy current sensor on the component.

The system of any preceding clause, wherein the controller is further configured to: determine the curvature for the first sensor element in the deformed state is based on a curvature machine learning algorithm that is trained on a plurality of known curvatures associated with known strain tensor components.

The system of any preceding clause, wherein the controller is further configured to: determine the curvature for the first sensor element is based on a metric tensor for the first sensor element in the deformed state; and determine the metric tensor for the first sensor element in the deformed state based on a metric tensor machine learning algorithm that is trained on a plurality of known metric tensors for known sensor element shapes.

The system of any preceding clause, wherein the controller is further configured to: determine an induced eddy current of the first sensor element in the deformed state based on the shape of the first sensor element in the deformed state; determine an impedance measurement for the first sensor element in the deformed state based on the induced eddy current; and determine the first correction is based on the impedance measurement for the first sensor element in the deformed state.

The system of any preceding clause, wherein the controller is configured to: determine a characteristic of a magnetic field of the first sensor element in the deformed state based on the shape of the first sensor element in the deformed state; and determine the induced eddy current of the first sensor element based on the characteristic of the magnetic field.

The system of any preceding clause, wherein the controller is further configured to: determine the one or more components of the strain tensor based on a strain machine learning algorithm that is trained on a plurality of known sensor element strains associated with known changes in impedances.

A method of operating a stretchable eddy current sensor for health monitoring of a component, the method comprising: coupling the stretchable eddy current sensor to a component, the coupling resulting in a sensor element of the stretchable eddy current sensor having an initial deformed shape; acquiring a baseline value for a parameter measured using the sensor element of the stretchable eddy current sensor, the baseline value acquired from the sensor element at a first time with the sensor element in the initial deformed shape; monitoring the component for a period of time using the sensor element to acquire an updated value for the parameter measured using the sensor element of the stretchable eddy current sensor; and identifying a defect in the component by comparing the updated value and the baseline value of the parameter measured using the sensor element.

The method of any preceding clause, further comprising: determining a correction for the sensor element in the initial deformed shape; and applying the correction to the updated value for the parameter.

A stretchable eddy current sensor comprising: a stretchable substrate; and an eddy current sensor element array comprising a plurality of coils disposed on the stretchable substrate.

The stretchable eddy current sensor of any preceding clause, wherein the eddy current sensor element array includes: at least one first sensor element that is elongated along a first axis; and at least one second sensor element that is elongated along a second axis, wherein the second axis is angled relative to the first axis.

The stretchable eddy current sensor of any preceding clause, wherein the second axis is substantially perpendicular to the first axis.

The stretchable eddy current sensor of any preceding clause, wherein the eddy current sensor element array further includes a circular coil.

The stretchable eddy current sensor of any preceding clause, wherein the eddy current sensor element array includes at least one of a sense coil or a drive coil.

The stretchable eddy current sensor of any preceding clause, wherein the plurality of coils includes at least one of a circular coil, a rectangular coil, an elliptical coil, or a square coil.

The stretchable eddy current sensor of any preceding clause, wherein the plurality of coils of the eddy current sensor element array are in communication with a controller, and wherein, for one or more of the plurality of coils, the controller is configured to determine a strain for a sensor element to determine a correction for the sensor element and determine a value for a parameter measured using the sensor element to perform an inspection.

A method of calibrating a stretchable eddy current sensor to account for variations in an eddy current response of the stretchable eddy current sensor due to deformations, the method comprising: determining a change in impedance of a sensor element of the stretchable eddy current sensor, the change in impedance representing a difference in impedance of the sensor element in a deformed state and an undeformed state; determining one or more components of a strain tensor for the sensor element based on the change in impedance; determining an eddy current response of the sensor element in the deformed state based on the one or more components of the strain tensor; and determining a correction for values measured by the sensor element in the deformed state based on the eddy current response.

The method of any preceding clause, wherein the eddy current response includes at least one of a magnetic field, an induced eddy current, or an impedance measurement of the sensor element in the deformed state.

The method of any preceding clause, further comprising: measuring an initial impedance for the sensor element, the initial impedance representing impedance of the sensor element in the undeformed state; measuring a final impedance for the sensor element, the final impedance representing impedance of the sensor element in the deformed state; and determining a difference between the initial impedance and the final impedance, the difference representing the change in impedance.

The method of any preceding clause, further comprising: determining a shape of the sensor element in the deformed state based on the change in impedance, wherein the eddy current response is determined based on the shape.

The method of any preceding clause, further comprising: determining at least one of a deformation or a curvature for the sensor element in the deformed state based on the one or more components of the strain tensor, wherein the shape of the sensor element in the deformed state is determined based on at least one of the deformation or the curvature of the sensor element.

The method of any preceding clause, further comprising: determining at least one of a deformation or a curvature for the sensor element in the deformed state based on the one or more components of the strain tensor, wherein the shape of the sensor element in the deformed state is determined based on geometry information of a component being inspected and position information indicating a position of the stretchable eddy current sensor on the component.

The method of any preceding clause, wherein the curvature for the sensor element in the deformed state is determined using a curvature machine learning algorithm that is trained on a plurality of known curvatures associated with known strain tensor components.

The method of any preceding clause, wherein the curvature for the sensor element is based on a metric tensor for the sensor element in the deformed state.

The method of any preceding clause, wherein the metric tensor for the sensor element in the deformed state is determined using a metric tensor machine learning algorithm that is trained on a plurality of known metric tensors for known sensor element shapes.

The method of any preceding clause, further comprising: determining an induced eddy current of the sensor element in the deformed state based on the shape of the sensor element in the deformed state; and determining an impedance measurement for the sensor element in the deformed state based on the induced eddy current, wherein the correction is based on the impedance measurement for the sensor element in the deformed state.

The method of any preceding clause, further comprising: determining a characteristic of a magnetic field of the sensor element in the deformed state based on the shape of the sensor element in the deformed state, wherein the induced eddy current of the sensor element is determined based on the characteristic of the magnetic field.

The method of any preceding clause, further comprising: adjusting an inspection value measured by the sensor element using the correction, wherein the correction is implemented using a signal filter.

The method of any preceding clause, wherein the characteristic of the magnetic field in the deformed state is determined using a magnetic field machine learning algorithm that is trained on a plurality of known magnetic fields resulting from known deformed sensor element shapes.

The method of any preceding clause, wherein the one or more components of the strain tensor are determined using a strain machine learning algorithm that is trained on a plurality of known sensor element strains associated with known changes in impedances.

The method of any preceding clause, further comprising: adjusting an inspection value measured by the sensor element using the correction, the inspection value acquired from the sensor element in the deformed state.

The method of any preceding clause, wherein the correction is a gain signal that is applied to output signals from the sensor element of the stretchable eddy current sensor.

A method of operating a stretchable eddy current sensor for health monitoring of a component, the method comprising: coupling the stretchable eddy current sensor to a component, the coupling resulting in a sensor element of the stretchable eddy current sensor having an initial deformed shape; acquiring a baseline value for a parameter measured using the sensor element of the stretchable eddy current sensor, the baseline value acquired from the sensor element at a first time with the sensor element in the initial deformed shape; monitoring the component for a period of time using the sensor element to acquire an updated value for the parameter measured using the sensor element of the stretchable eddy current sensor; and identifying a defect in the component by comparing the updated value and the baseline value of the parameter measured using the sensor element.

The method of any preceding clause, further comprising: determining a correction for the sensor element in the initial deformed shape; and applying the correction to the updated value for the parameter.

The method of any preceding clause, wherein the correction is implemented using a signal filter to compensate for variation in the parameter due to the initial deformed shape.

A method of operating a stretchable eddy current sensor to mitigate sensor deformation effects, the stretchable eddy current sensor comprising an eddy current sensor element array including a first sensor element and a second sensor element, the method comprising: determining a first strain on the first sensor element based on a impedance of the first sensor element; applying a first correction to the first sensor element based on the first strain; determining a second strain on the second sensor element based on a impedance of the second sensor element; and applying a second correction to the second sensor element based on the second strain.

The method of any preceding clause, wherein the first correction is a first gain signal applied to an output signal of the first sensor element, and wherein the second correction is a second gain signal applied to an output signal of the second sensor element.

## Claims

1. A system (100) comprising:
a stretchable eddy current sensor (108) comprising:
a stretchable substrate (144) (176); and
an eddy current sensor (108) element array comprising a plurality of sensor (108) elements (111) disposed on the stretchable substrate (144) (176), the plurality of sensor (108) elements (111) including at least one drive element and at least one sense element.

2. The system (100) of claim 1, wherein the eddy current sensor (108) element array includes:
a first sensor (108) element (172) that is elongated along a first axis; and
a second sensor (108) element (174) that is elongated along a second axis, wherein the second axis is angled relative to the first axis.

3. The system (100) of claim 1 or 2, wherein the at least one sense element includes a coil (160) or a magnetoresistive sensor (108), and wherein the coil (160) is a circular coil (160) (142), a rectangular coil (160), an elliptical coil (160), a square coil (160), or a continuous wave shaped coil (160).

4. The system (100) of any of claims 1 to 3, further comprising:
a controller (120) in communication with the stretchable eddy current sensor (108), wherein the controller (120) is configured to:
determine a first strain for a first sensor (108) element (172) of the plurality of sensor (108) elements (111) to determine a first correction for the first sensor (108) element (172); and
determine a value for a parameter measured using the first sensor (108) element (172) to perform an inspection.

5. The system (100) of claim 4, wherein the controller (120) is further configured to:
determine the first strain on the first sensor (108) element (172) based on an impedance of the first sensor (108) element (172); and
apply the first correction to the first sensor (108) element (172) based on the first strain.

6. The system (100) of claim 5, wherein the controller (120) is further configured to:
determine a second strain on a second sensor (108) element (174) of the plurality of sensor (108) elements (111) based on an impedance of the second sensor (108) element (174); and
apply a second correction to the second sensor (108) element (174) based on the second strain.

7. The system (100) of claim 6, wherein the first correction is a first gain and/or phase signal applied to an output signal of the first sensor (108) element (172), and wherein the second correction is a second gain and/or phase signal applied to an output signal of the second sensor (108) element (174).

8. The system (100) of claim 5, wherein the controller (120) is further configured to:
determine a change in impedance of the first sensor (108) element (172), the change in impedance representing a difference in impedance of the first sensor (108) element (172) in a deformed state and an undeformed state;
determine one or more components of a strain tensor for the first sensor (108) element (172) based on the change in impedance;
determine an eddy current response of the first sensor (108) element (172) in the deformed state based on the one or more components of the strain tensor; and
determine the first correction based on the eddy current response.

9. The system (100) of claim 8, wherein the eddy current response includes at least one of a magnetic field, an induced eddy current, or an impedance measurement of the first sensor (108) element (172) in the deformed state.

10. The system (100) of claim 8, wherein the controller (120) is further configured to:
measure an initial impedance for the first sensor (108) element (172), the initial impedance representing impedance of the first sensor (108) element (172) in the undeformed state;
measure a final impedance for the first sensor (108) element (172), the final impedance representing impedance of the first sensor (108) element (172) in the deformed state; and
determine a difference between the initial impedance and the final impedance, the difference representing the change in impedance.

11. The system (100) of claim 8, wherein the controller (120) is further configured to:
determine a shape of the first sensor (108) element (172) in the deformed state based on the change in impedance; and
determine the eddy current response based on the shape.

12. The system (100) of claim 11, wherein the controller (120) is further configured to:
determine at least one of a deformation or a curvature for the first sensor (108) element (172) in the deformed state based on the one or more components of the strain tensor; and
determine the shape of the first sensor (108) element (172) in the deformed state based on at least one of the deformation or the curvature of the first sensor (108) element (172).

13. The system (100) of claim 12, wherein the controller (120) is further configured to:
determine at least one of a deformation or a curvature for the first sensor (108) element (172) in the deformed state based on the one or more components of the strain tensor; and
determine the shape of the first sensor (108) element (172) in the deformed state based on geometry information of a component (104) being inspected and position information indicating a position of the stretchable eddy current sensor (108) on the component (104).

14. The system (100) of claim 12, wherein the controller (120) is further configured to:
determine the curvature for the first sensor (108) element (172) in the deformed state is based on a curvature machine learning algorithm that is trained on a plurality of known curvatures associated with known strain tensor components.

15. The system (100) of claim 12, wherein the controller (120) is further configured to:
determine the curvature for the first sensor (108) element (172) is based on a metric tensor for the first sensor (108) element (172) in the deformed state; and
determine the metric tensor for the first sensor (108) element (172) in the deformed state based on a metric tensor machine learning algorithm that is trained on a plurality of known metric tensors for known sensor (108) element shapes.
